# EUROPEAN PATENT APPLICATION

(11) **EP 4 489 529 A1**
(43) Date of publication of application: **08.01.2025**
(21) Application number: 23763371.4
(22) Date of filing: 24.02.2023
(51) Int. Cl.: H05K 1/16, H02K 3/26

(54) **COIL SUBSTRATE, MOTOR COIL SUBSTRATE, AND MOTOR**

(30) Priority: 04.03.2022 JP 2022033055
(71) Applicant: IBIDEN CO., LTD., Ogaki-shi, Gifu 503-8604 (JP)
(72) Inventor: HIRASAWA, Takahisa, Ogaki-shi, Gifu 503-8503 (JP); FURUNO, Takayuki, Ogaki-shi, Gifu 503-8503 (JP)
(74) Representative: Hoefer & Partner Patentanwälte mbB
(86) International application number: PCT/JP2023/006880
(87) International publication number: WO 2023/167112

(57) **Abstract**

Provided are a coil substrate that makes it possible to achieve a motor that has stable performance, a motor coil substrate that is formed using the coil substrate, and a motor that is formed using the motor coil substrate. According to the present invention, a coil substrate includes a flexible substrate that has a first surface and a second surface that is on the reverse side from the first surface, a coil that is formed from coil-shaped wiring that is provided on the first surface and coil-shaped wiring that is provided on the second surface, a terminal that is formed at one edge of the flexible substrate in the width direction, and a connection wire that connects the terminal and the wiring of the coil or a connection wire that connects the two wirings of the coil. The coil substrate can be given a cylindrical shape by being wound along the longitudinal direction of the flexible substrate from a reference edge that is on one end side in the longitudinal direction around an axis that extends in a perpendicular direction that is perpendicular to the longitudinal direction. The connection wire extends diagonally relative to the longitudinal direction.

## Description

### [Technical Field]

The technology disclosed in the present specification relates to a coil board, a motor coil board formed by using the coil board, and a motor formed by using the motor coil board.

### [Background Art]

Patent Document 1 describes a coil board comprising a flexible board and coils formed on the flexible board. The coil board has connecting wires for connecting the coils and terminals. A cylindrical motor coil board is formed by is formed by winding the coil board around a cavity.

### [Prior Art Documents]

### [Patent Documents]

[Patent Document 1] JP 2021-48718A

### [Summary of the Invention]

### [Problems in Patent Document 1]

In the technology of Patent Document 1, it is feasible for the connecting wires to extend in a direction which is orthogonal (i.e., an orthogonal direction of the flexible board) to a direction in which the coil board is wound (i.e., a longitudinal direction). It is also feasible for gaps between adjacent connecting wires to be formed along the orthogonal direction. When the coil board is wound, it is feasible that a force will be readily applied to the gap parts where there is no wiring, making folds likely to form. As a result, it is feasible that the motor coil board will be formed in a polygonal cylinder shape with a polygonal cross section, rather than a cylindrical shape with a circular cross section.

If the motor coil board has a polygonal cylinder shape, it is feasible that this will interfere with a magnet which is arranged on the inside when a motor is formed. Furthermore it is feasible that there will be a reduction in heat dissipation because a space between the motor coil board and a yoke is not constant. It is feasible that stable motor performance may not be demonstrated as a result.

### [Means for Solving the Problems]

A coil board according to the present invention comprises: a flexible board having a first face and a second face on the opposite side to the first face; coils formed by coil-shaped wiring provided on the first face and coil-shaped wiring provided on the second face; terminals formed on one edge in a width direction of the flexible board; and connecting wires for connecting the terminals and the wiring of the coils, or connecting wires for connecting the wiring of two coils. The coil board is wound along a longitudinal direction of the flexible board about an axis extending in an orthogonal direction which is orthogonal to the longitudinal direction, starting from a reference edge on one end side of the flexible board in the longitudinal direction, and can thereby be formed into a cylindrical shape. The connecting wires extend obliquely in relation to the longitudinal direction.

The connecting wires extend obliquely in relation to the longitudinal direction in the coil board according to the present invention. The formation of gaps between adjacent connecting wires along the orthogonal direction is therefore suppressed. When the coil board is wound, folding at the gap parts between connecting wires is suppressed. When a motor coil board is formed by winding the coil board according to the present invention in a circumferential direction, the motor coil board can therefore be formed into a cylindrical shape with a circular cross section. Short-circuiting between the wiring is therefore suppressed. As a result, interference is prevented between the motor coil board and a magnet which is arranged on the inside of the motor coil board when a motor is formed by arranging the motor coil board, the magnet, and a yoke inside a housing. Furthermore, high heat dissipation is achieved because the space between the motor coil board and the yoke is constant. When a motor is formed by using the coil board according to the present invention, a motor having stable performance can therefore be obtained.

In the coil board according to the present invention, a gap which is formed between two adjacent connecting wires may extend obliquely in relation to the longitudinal direction.

In the coil board according to the present invention, the connecting wires may include a first face-side connecting wire formed on the first face side, and a second face-side connecting wire formed on the second face side. The first face-side connecting wire and the second face-side connecting wire may extend in intersecting directions, when the flexible board is seen from the first face side.

In the coil board according to the present invention, the coils may comprise first wiring constituting a half turn of one turn formed on the first face side, and second wiring constituting a remaining half turn formed on the second face side, and the first wiring and the second wiring constituting each turn may be electrically connected through a via conductor.

In the coil board according to the present invention, the connecting wires may be inclined by +5° or more, or -5° or more, in relation to an imaginary line parallel to the orthogonal direction.

In the coil board according to the present invention, the connecting wires may be inclined by +10° to +45°, or -10° to -45°, in relation to an imaginary line parallel to the orthogonal direction.

A motor coil board according to the present invention is formed by winding the coil board according to the present invention into a cylindrical shape. The first face is arranged on an inner circumferential side, and the second face is arranged on an outer circumferential side.

The motor coil board according to the present invention can be formed with a circular cross section. Short-circuiting between the wiring is therefore suppressed. Interference is prevented between the magnet and the motor coil board when a motor is formed by arranging the motor coil board, the magnet, and a yoke inside a housing. High heat dissipation is achieved. When a motor is formed by using the motor coil board according to the present invention, a motor having stable performance can therefore be obtained.

A motor according to the present invention is formed by arranging the motor coil board according to the present invention on the inside of a cylindrical yoke, and arranging a rotary shaft and a magnet on the inside of the motor coil board.

Interference between the magnet and the motor coil board is prevented in the motor according to the present invention. Furthermore, high heat dissipation is achieved because the space between the motor coil board and the yoke is constant. A motor having stable performance is obtained.

### [Brief Description of the Drawings]

[Fig. 1] is a plan view schematically showing a coil board according to an embodiment.
[Fig. 2] is a view in cross section schematically showing the coil board according to the embodiment.
[Fig. 3] is a plan view schematically showing a U phase of the coil board according to the embodiment.
[Fig. 4] is a plan view schematically showing a V phase of the coil board according to the embodiment.
[Fig. 5] is a plan view schematically showing a W phase of the coil board according to the embodiment.
[Fig. 6] is a plan view contrasting the U phase, V phase and W phase of the coil board according to the embodiment.
[Fig. 7] is an enlarged illustrative diagram schematically showing a portion of the coil board according to the embodiment.
[Fig. 8] is an oblique view schematically showing a motor coil board according to the embodiment.
[Fig. 9] is a view in cross section schematically showing a motor according to the embodiment.
[Fig. 10] is a plan view schematically showing a coil board according to modified example 1 of the embodiment.
[Fig. 11] is a plan view schematically showing a U phase of the coil board according to modified example 1 of the embodiment.
[Fig. 12] is a plan view schematically showing a V phase of the coil board according to modified example 1 of the embodiment.
[Fig. 13] is a plan view schematically showing a W phase of the coil board according to modified example 1 of the embodiment.
[Fig. 14] is a plan view contrasting the U phase, V phase and W phase of the coil board according to modified example 1 of the embodiment.
[Fig. 15] is a plan view schematically showing a coil board according to modified example 2 of the embodiment.
[Fig. 16] is a plan view schematically showing a U phase of the coil board according to modified example 2 of the embodiment.
[Fig. 17] is a plan view schematically showing a V phase of the coil board according to modified example 2 of the embodiment.
[Fig. 18] is a plan view schematically showing a W phase of the coil board according to modified example 2 of the embodiment.
[Fig. 19] is a plan view contrasting the U phase, V phase and W phase of the coil board according to modified example 2 of the embodiment.

### [Embodiment of the Invention]

### [Embodiment]

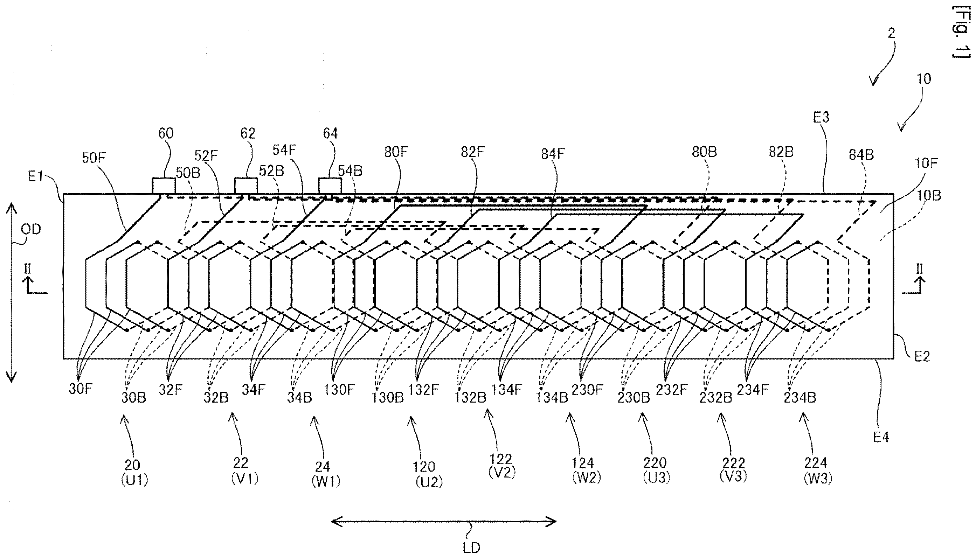

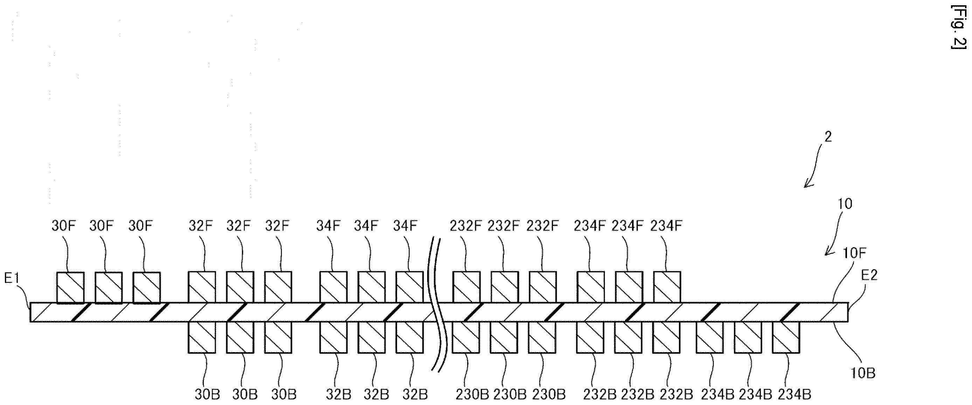

Fig. 1 is a plan view showing a coil board 2 according to an embodiment. Fig. 2 is a view in the cross section II-II in fig. 1. As shown in fig. 1, the coil board 2 comprises: a flexible board 10; nine coils 20, 22, 24, 120, 122, 124, 220, 222, 224; three terminals 60, 62, 64; and connecting wires 50F, 50B, 52F, 52B, 54F, 54B, 80F, 80B, 82F, 82B, 84F, 84B.

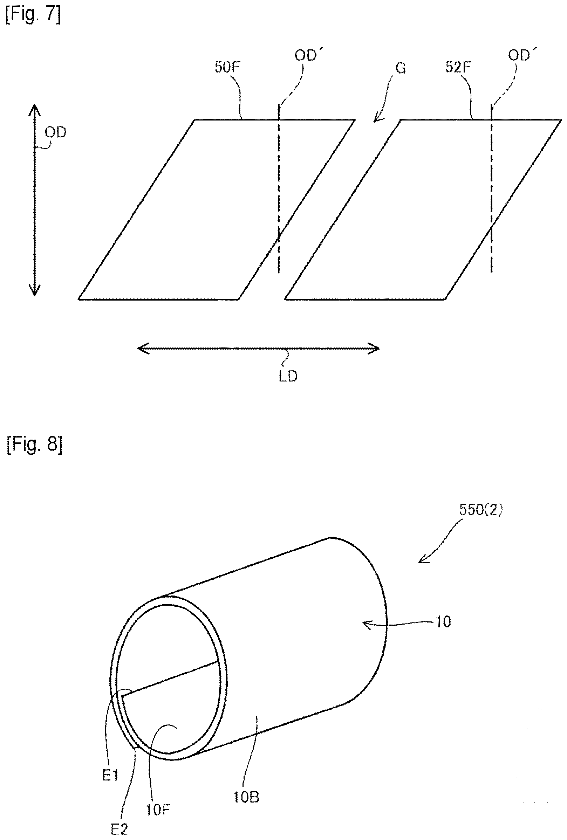

The flexible board 10 is a resin board comprising a first face 10F and a second face 10B on the opposite side to the first face 10F. The flexible board 10 is formed by using an insulating resin such as polyimide or polyamide. The flexible board 10 is capable of flexing. The flexible board 10 is formed in a rectangular shape with four edges, which are a first edge E1 to a fourth edge E4. The first edge E1 is a short edge on one end side of the flexible board 10 in a longitudinal direction (direction of the arrow LD in fig. 1). The second edge E2 is a short edge on the other end side in the longitudinal direction. The first edge E1 and the second edge E2 are both short edges extending along an orthogonal direction (direction of the arrow OD in fig. 1) which is orthogonal to the longitudinal direction. The third edge E3 and the fourth edge E4 are both long edges extending along the longitudinal direction. When the coil board 2 is wound into a cylindrical shape to form a motor coil board 550 (see fig. 8), the first face 10F is arranged on an inner circumferential side and the second face 10B is arranged on an outer circumferential side.

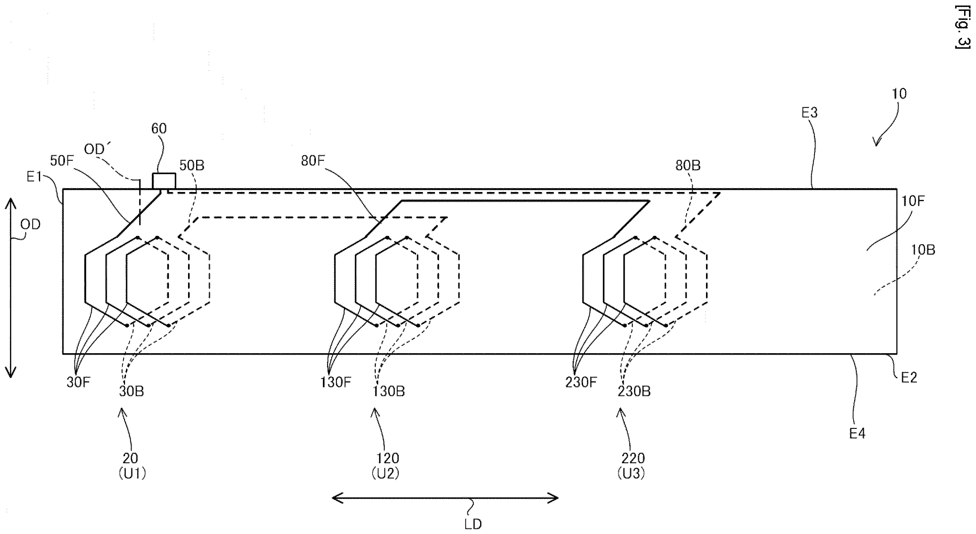

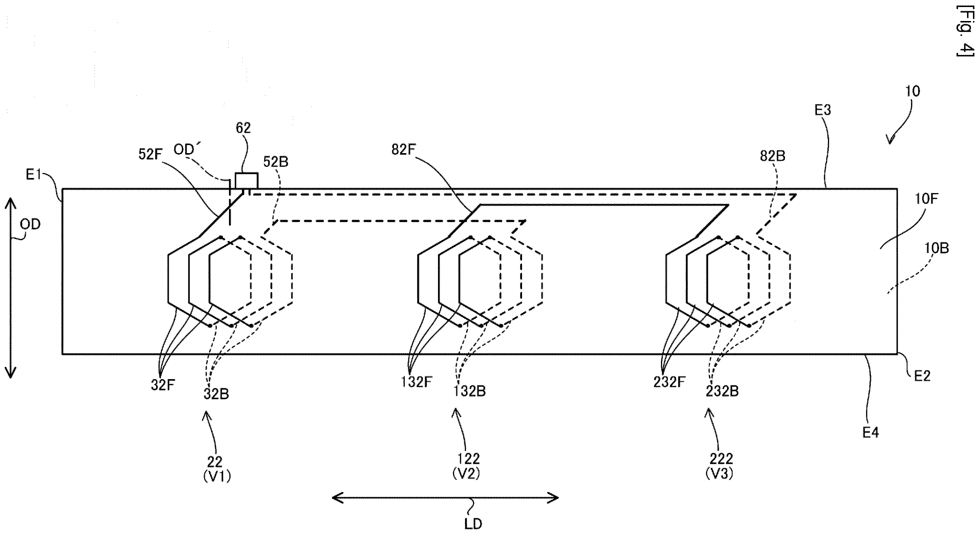

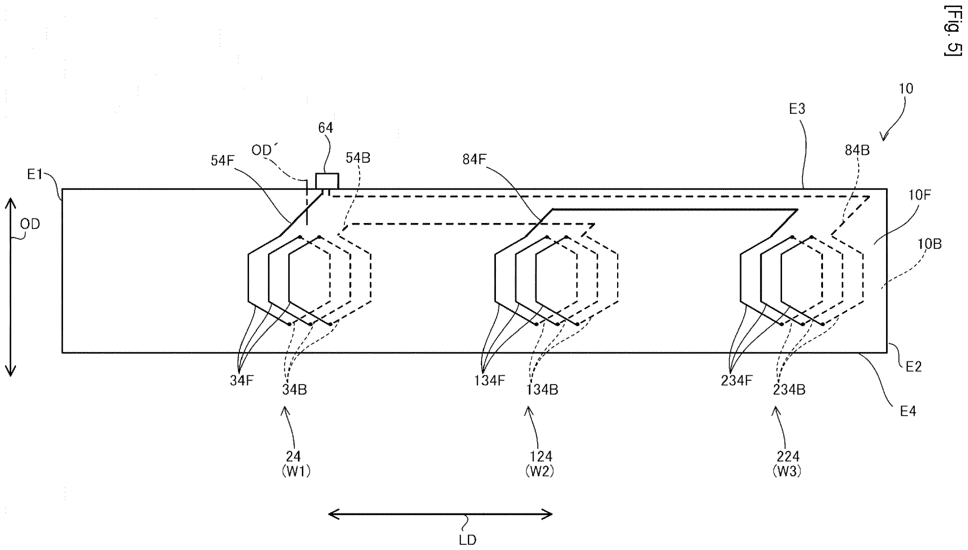

The three terminals 60, 62, 64 are formed at intervals along the longitudinal direction on the third edge E3 of the flexible board 10. As shown in fig. 3, the coils 20, 120, 220 are connected to the terminal 60 by way of the connecting wires 50F, 50B, 80F, 80B. As shown in fig. 4, the coils 22, 122, 222 are connected to the terminal 62 by way of the connecting wires 52F, 52B, 82F, 82B. As shown in fig. 5, the coils 24, 124, 224 are connected to the terminal 64 by way of the connecting wires 54F, 54B, 84F, 84B.

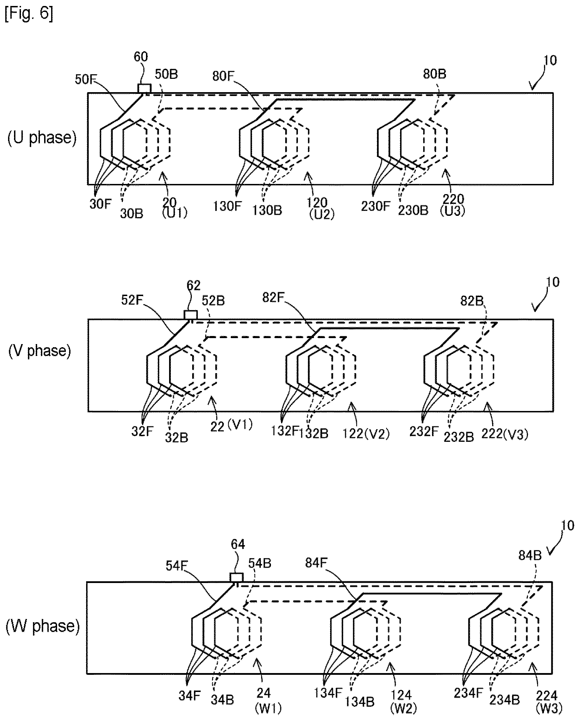

As shown in fig. 1, the nine coils 20, 22, 24, 120, 122, 124, 220, 222, 224 are aligned along the longitudinal direction of the flexible board 10. The nine coils 20, 22, 24, 120, 122, 124, 220, 222, 224 are aligned in that order from the first edge E1 toward the second edge E2. As shown in fig. 3 and 6, the coils 20 (U1), 120 (U2), 220 (U3) constitute a U phase. As shown in fig. 4 and 6, the coils 22 (V1), 122 (V2), 222 (V3) constitute a V phase. As shown in fig. 5 and 6, the coils 24 (W1), 124 (W2), 224 (W3) constitute a W phase. As shown in fig. 6, the U phase, V phase and W phase are each arranged offset from each other along the longitudinal direction. The nine coils 20, 22, 24, 120, 122, 124, 220, 222, 224 are aligned along the longitudinal direction in the order of U phase, V phase and W phase. The U phase, V phase and W phase of a three-phase motor may be constructed in a different form to that described above.

As shown in fig. 1 and 3, in order to form the coil 20, first wiring 30F constituting a half turn of one turn is formed on the first face 10F side, second wiring 30B constituting a remaining half turn is formed on the second face 10B side, and adjacent turns are arranged offset from each other. In fig. 1, the coil 20 comprises three turns of wiring. The first wiring 30F and the second wiring 30B constituting each turn are electrically connected through via conductors penetrating the flexible board 10. The first wiring 30F has orthogonal portions extending along the orthogonal direction (see the arrow OD). The second wiring 30B also has orthogonal portions extending along the orthogonal direction.

In the same way, as shown in fig. 1 and 4, in order to form the coil 22, first wiring 32F constituting a half turn of one turn is formed on the first face 10F side, second wiring 32B constituting a remaining half turn is formed on the second face 10B side, and adjacent turns are arranged offset from each other. The coil 22 comprises three turns of wiring. The first wiring 32F and the second wiring 32B constituting each turn are electrically connected through via conductors. The first wiring 32F has orthogonal portions extending along the orthogonal direction (see the arrow OD). The second wiring 32B also has orthogonal portions extending along the orthogonal direction.

As shown in fig. 1 and 5, in order to form the coil 24, first wiring 34F constituting a half turn of one turn is formed on the first face 10F side, second wiring 34B constituting a remaining half turn is formed on the second face 10B side, and adjacent turns are arranged offset from each other. The coil 24 comprises three turns of wiring. The first wiring 34F and the second wiring 34B constituting each turn are electrically connected through via conductors. The first wiring 34F has orthogonal portions extending along the orthogonal direction (see the arrow OD). The second wiring 34B also has orthogonal portions extending along the orthogonal direction.

The coils 120, 122, 124, 220, 222, 224 also have the same configuration as the coils 20, 22, 24. That is to say, the coils 120, 122, 124 also comprise three turns of first wiring 130F, 132F, 134F and second wiring 130B, 132B, 134B. The coils 220, 222, 224 also comprise three turns of first wiring 230F, 232F, 234F and second wiring 230B, 232B, 234B.

As shown in fig. 1 and 2, the orthogonal portions (the parts extending along the orthogonal direction OD; the same hereinafter) of the second wiring 30B constituting the coil 20 overlap, through the flexible board 10, the orthogonal portions of the first wiring 32F constituting the adjacent coil 22. The orthogonal portions of the second wiring 32B constituting the coil 22 overlap, through the flexible board 10, the orthogonal portions of the first wiring 34F constituting the adjacent coil 24.

In the same way, the orthogonal portions of the second wiring 34B constituting the coil 24 overlap the orthogonal portions of the first wiring 130F constituting the adjacent coil 120. The orthogonal portions of the second wiring 130B of the coil 120 overlap the orthogonal portions of the first wiring 132F of the adjacent coil 122. The orthogonal portions of the second wiring 132B of the coil 122 overlap the orthogonal portions of the first wiring 134F of the adjacent coil 124. The orthogonal portions of the second wiring 134B of the coil 124 overlap the orthogonal portions of the first wiring 230F of the adjacent coil 220. The orthogonal portions of the second wiring 230B of the coil 220 overlap the orthogonal portions of the first wiring 232F of the adjacent coil 222. The orthogonal portions of the second wiring 232B of the coil 222 overlap the orthogonal portions of the first wiring 234F of the adjacent coil 224.

The arrangement of the coils shown in fig. 1 and 2 is purely exemplary. In another modified example, the orthogonal portions of the second wiring 30B constituting the coil 20 need not overlap the orthogonal portions of the first wiring 32F constituting the immediately adjacent coil 22, provided that they overlap the orthogonal portions of first wiring constituting another coil (e.g., the orthogonal portions of the first wiring 130F of the coil 120 three along). In the same way, the orthogonal portions of the second wiring 32B constituting the coil 22 need not overlap the orthogonal portions of the first wiring 34F constituting the immediately adjacent coil 24, provided that they overlap the orthogonal portions of first wiring constituting another coil (e.g., the orthogonal portions of the first wiring 132F of the coil 122 three along).

As shown in fig. 1 and 3-6, the connecting wires 50F, 52F, 54F, 80F, 82F, 84F are formed on the first face 10F side. The connecting wires 50B, 52B, 54B, 80B, 82B, 84B are formed on the second face 10B side.

As shown in fig. 3 and 6, the connecting wire 50F connects an end portion of the first wiring 30F constituting one end of the coil 20, and the terminal 60. The connecting wire 50B connects an end portion of the second wiring 30B constituting the other end of the coil 20, and an end portion of the second wiring 130B constituting one end of the coil 120. The connecting wire 80F connects an end portion of the first wiring 130F constituting the other end of the coil 120, and an end portion of the first wiring 230F constituting one end of the coil 220. The connecting wire 80B connects an end portion of the second wiring 230B constituting the other end of the coil 120, and the terminal 60. That is to say, the coils 20, 120, 220 constituting the U phase are connected in series by way of the connecting wires 50F, 50B, 80F, 80B and the terminal 60.

As shown in fig. 4 and 6, the connecting wire 52F connects an end portion of the first wiring 32F constituting one end of the coil 22, and the terminal 62. The connecting wire 52B connects an end portion of the second wiring 32B constituting the other end of the coil 22, and an end portion of the second wiring 132B constituting one end of the coil 122. The connecting wire 82F connects an end portion of the first wiring 132F constituting the other end of the coil 122, and an end portion of the first wiring 232F constituting one end of the coil 222. The connecting wire 82B connects an end portion of the second wiring 232B constituting the other end of the coil 122, and the terminal 62. The coils 22, 122, 222 constituting the V phase are connected in series by way of the connecting wires 52F, 52B, 82F, 82B and the terminal 62.

As shown in fig. 5 and 6, the connecting wire 54F connects an end portion of the first wiring 34F constituting one end of the coil 24, and the terminal 64. The connecting wire 54B connects an end portion of the second wiring 34B constituting the other end of the coil 24, and an end portion of the second wiring 134B constituting one end of the coil 124. The connecting wire 84F connects an end portion of the first wiring 134F constituting the other end of the coil 124, and an end portion of the first wiring 234F constituting one end of the coil 224. The connecting wire 84B connects an end portion of the second wiring 234B constituting the other end of the coil 124, and the terminal 64. The coils 24, 124, 224 constituting the W phase are connected in series by way of the connecting wires 54F, 54B, 84F, 84B and the terminal 64.

As shown in fig. 1 and 3-6, the connecting wires 50F, 52F, 54F, 80F, 82F, 84F formed on the first face 10F side extend obliquely (are inclined) in relation to the longitudinal direction (direction of the arrow LD in fig. 1). The connecting wires 50F, 52F, 54F, 80F, 82F, 84F are all largely free of parts extending in the orthogonal direction (direction of the arrow OD). The connecting wires 50F, 52F, 54F, 80F, 82F, 84F extend obliquely (are inclined) in relation to the orthogonal direction. Fig. 7 is an enlarged illustrative diagram schematically showing the connecting wire 50F and the connecting wire 52F which are adjacently arranged on the first face 10F side. As shown in fig. 7, the connecting wire 50F and the connecting wire 52F both constitute wide wiring. In the example of fig. 7, the connecting wire 50F and the connecting wire 52F are formed parallel to each other. The connecting wire 50F and the connecting wire 52F are inclined in relation to both the longitudinal direction and the orthogonal direction. Furthermore, a gap G formed between the connecting wire 50F and the connecting wire 52F is also inclined in relation to both the longitudinal direction and the orthogonal direction. The connecting wire 50F and the connecting wire 52F are both inclined, for example, by +5° or more, or-5° or more in relation to an imaginary line OD' parallel to the orthogonal direction, in terms of an interior angle formed by the imaginary line OD' and the connecting wires 50F, 52F. As a result of the connecting wires 50F, 52F being inclined by +5° or more, or -5° or more in relation to the imaginary line OD', the coil board 2 is formed into a cylindrical shape when it is wound, rather than being formed into a polygonal cylinder shape with a polygonal cross section. In addition, an inclination of +10° to +45° in relation to the imaginary line OD' is preferable for the interior angle with the connecting wires 50F, 52F. Furthermore, an inclination of -10° to -45° in relation to the imaginary line OD' is preferable. When the coil board 2 in which the connecting wires 50F, 52F are inclined by +10° to +45° in relation to the imaginary line OD' or are inclined by -10° to -45° in relation to the imaginary line OD' is wound, the coil board 2 is formed into a cylindrical shape, rather than being formed into a polygonal cylinder shape with a polygonal cross section. In addition, there is also less need to rewind the coil board 2 because of winding misalignment occurring at the end of winding. As a result, a motor coil board obtained by winding the coil board 2 can be formed into a cylindrical shape with a circular cross section. It should be noted that the inclination of the connecting wires 50F, 52F is measured by a protractor on the basis of an image captured from a front face of the wiring. In this embodiment, the connecting wires 50F, 52F are inclined by +30° in relation to the imaginary line OD'. The interior angle in fig. 7 is a plus direction inclination when a point of intersection of the imaginary line OD' and the connecting wires 50F, 52F slopes up and to the right of the imaginary line OD', and, conversely, is a minus direction inclination when the point of intersection slopes up and to the left of the imaginary line OD'. Only the adjacent connecting wire 50F and connecting wire 52F are shown by way of example in fig. 7. The connecting wire 52F and connecting wire 54F, the connecting wire 80F and connecting wire 82F, and the connecting wire 82F and connecting wire 84F also each have the same relationship, although this is not shown in fig. 7. As shown in fig. 3-5, the connecting wires 54F, 80F, 82F, 84F are also inclined at the same angle as the connecting wires 50F, 52F.

As shown in fig. 1 and 3-6, the connecting wires 50B, 52B, 54B, 80B, 82B, 84B formed on the second face 10B side also all extend obliquely (are inclined) in relation to the longitudinal direction (direction of the arrow LD). The connecting wires 50B, 52B, 54B, 80B, 82B, 84B are also all largely free of parts extending in the orthogonal direction (direction of the arrow OD). The connecting wires 50B, 52B, 54B, 80B, 82B, 84B extend obliquely (are inclined) in relation to the orthogonal direction. As shown in fig. 3-5, the connecting wires 50B, 52B, 54B, 80B, 82B, 84B are inclined, for example, by +5° or more, or -5° or more in relation to the imaginary line OD' parallel to the orthogonal direction, in terms of the interior angle formed by the imaginary line OD' and the connecting wires 50B, 52B, 54B, 80B, 82B, 84B. In addition, +10° to +45° in relation to the imaginary line OD' is preferable for the interior angle with the connecting wires 50B, 52B, 54B, 80B, 82B, 84B. As a result, a motor coil board obtained by winding the coil board can be formed into a cylindrical shape with a circular cross section. The gaps which are respectively formed between the connecting wire 50B and the connecting wire 52B, between the connecting wire 52B and the connecting wire 54B, between the connecting wire 54B and the connecting wire 80B, between the connecting wire 80B and the connecting wire 82B, and between the connecting wire 82B and the connecting wire 84B also extend obliquely in relation to the longitudinal direction. The interior angles in each of the drawings are plus direction inclinations when the point of intersection of the imaginary line OD' and the connecting wires 50B, 52B, 54B, 80B, 82B, 84B slopes up and to the right of the imaginary line OD', and, conversely, are minus direction inclinations when the point of intersection slopes up and to the left of the imaginary line OD'.

The connecting wires connecting the coils and the terminals comprise: the connecting wires 50F, 52F, 54F, 80F, 82F, 84F formed on the first face 10F side, and the connecting wires 50B, 52B, 54B, 80B, 82B, 84B formed on the second face 10B side. The connecting wires 50F, etc. formed on the first face 10F side and the connecting wires 50B, etc. formed on the second face 10B side may extend in the same direction (at the same angle of inclination), when the flexible board 10 is seen from the first face 10F side. Conversely, the connecting wires 50F, etc. formed on the first face 10F side and the connecting wires 50B, etc. formed on the second face 10B side may extend in intersecting directions (at different angles of inclination), when the flexible board 10 is seen from the first face 10F side. Furthermore, connecting wires extending in the same direction and connecting wires extending in intersecting directions may be appropriately combined. The angles at which the connecting wires extend (angles of inclination) may all be the same, or some or all of the angles may be different.

Furthermore, the first face 10F, the first wiring 30F, 32F, 34F, 130F, 132F, 134F, 230F, 232F, 234F, and the connecting wires 50F, 52F, 54F, 80F, 82F, 84F are covered over by a resin insulating layer, although this is not shown in the drawings. The second face 10B, the second wiring 30B, 32B, 34B, 130B, 132B, 134B, 230B, 232B, 234B, and the connecting wires 50B, 52B, 54B, 80B, 82B, 84B are likewise covered over by a resin insulating layer.

Fig. 8 is an oblique view schematically showing a motor coil board 550 employing the coil board 2 (fig. 1-7) of the embodiment. As shown in fig. 8, the motor coil board 550 for a motor is formed by winding the coil board 2 (fig. 1-7) of the embodiment into a cylindrical shape. When wound into a cylindrical shape, the coil board 2 is wound multiple times about an axis extending in the orthogonal direction (an axis extending parallel to the first edge E1 (fig. 1)), starting from the first edge E1. Furthermore, the number of times that the coil board is wound is not particularly limited. The first face 10F of the flexible board 10 is arranged on the inner circumferential side, and the second face 10B is arranged on the outer circumferential side when the coil board 2 is wound into a cylindrical shape. Moreover, the first face 10F of the flexible board 10 may equally be arranged on the outer circumferential side, and the second face 10B may equally be arranged on the inner circumferential side when the coil board 2 is wound into a cylindrical shape. The manner of winding is determined according to the specification of the coil board 2 and the design, such as the width and thickness of wiring.

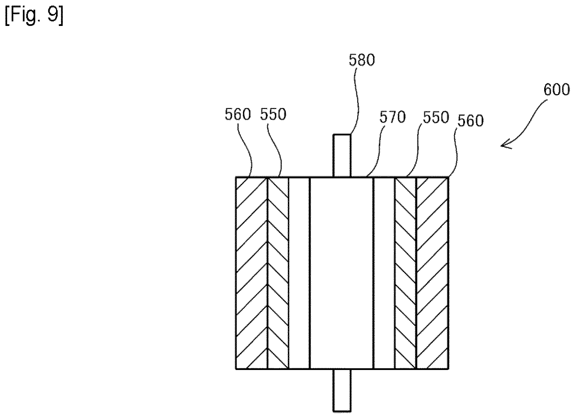

Fig. 9 is a view in cross section schematically showing a motor 600 employing the motor coil board 550 (fig. 8) of the embodiment. The motor 600 is formed by arranging the motor coil board 550 on the inside of a yoke 560, and arranging a rotary shaft 580 and a magnet 570, which is fixed to the rotary shaft 580, on the inside of the motor coil board 550.

The configurations of the coil board 2 (fig. 1-7), the motor coil board 550 (fig. 8), and the motor 600 (fig. 9) of the embodiment have been described. The connecting wires 50F, 52F, 54F, etc. extend obliquely in relation to the longitudinal direction in the coil board 2 of this embodiment. The connecting wires 50F, 52F, 54F, etc. are all free of parts extending along the orthogonal direction. The gaps G (see fig. 7) between adjacent connecting wires 50F, 52F, etc. also extend obliquely in relation to the orthogonal direction. The gaps G are not formed along the orthogonal direction. When the coil board 2 is wound, folding at the gap G parts between the connecting wires 50F, 52F, etc. is therefore suppressed. When the motor coil board 550 is formed by winding the coil board 2 of the embodiment in the circumferential direction, the motor coil board 550 can be formed into a cylindrical shape with a circular cross section. Interference is prevented between the motor coil board 550 and the magnet 570 which is arranged on the inside of the motor coil board 550 when the motor 600 is formed. Furthermore, high heat dissipation is achieved because the space between the motor coil board 550 and the yoke 560 is constant. When the motor 600 is formed by using the coil board 2 of the embodiment, a motor 600 having stable performance can therefore be obtained.

### [Modified Example 1 of the Embodiment]

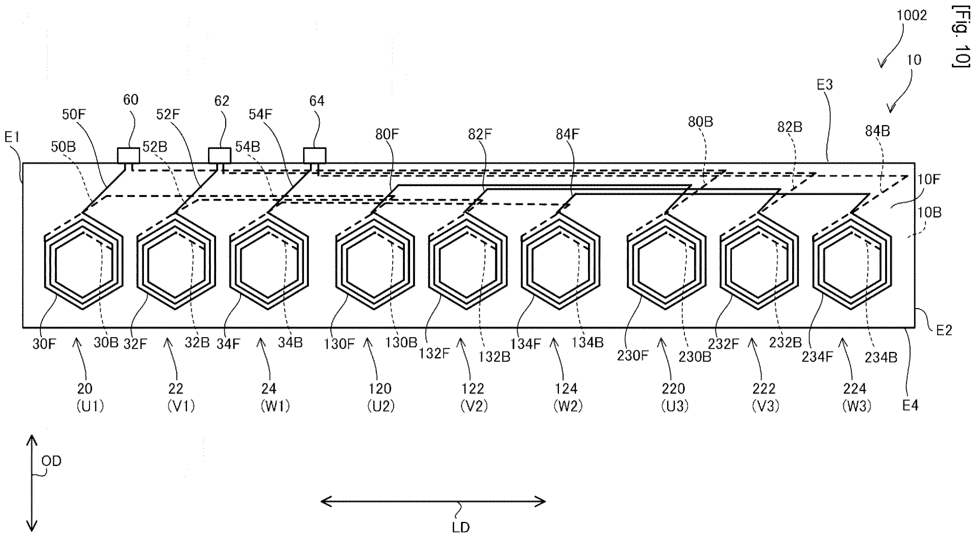

Fig. 10 shows modified example 1 of the embodiment. Fig. 10 is a plan view showing a coil board 1002 according to modified example 1. In modified example 1, the arrangement of the wiring constituting the coils 20, 22, 24, 120, 122, 124, 220, 222, 224, etc. differs from that of the embodiment.

In modified example 1 also, the coil 20 comprises coil-shaped first wiring 30F provided on the first face 10F, and coil-shaped second wiring 30B provided on the second face 10B. The first wiring 30F and the second wiring 30B are electrically connected through a via conductor penetrating the flexible board 10. The first wiring 30F is formed in a spiral shape (hexagonal spiral shape) from the outer circumference toward the inner circumference. A via conductor 40 is formed at an inner circumferential end of the first wiring 30F. Meanwhile, the second wiring 30B is formed in a spiral shape (hexagonal spiral shape) from the inner circumference toward the outer circumference. The via conductor 40 is formed at an inner circumferential end of the second wiring 30B. As shown in fig. 10, the first wiring 30F and the second wiring 30B are formed in a spiral shape with the same winding direction as seen from the same face. The first wiring 30F and the second wiring 30B function as a single coil 20 in which they are electrically connected in series.

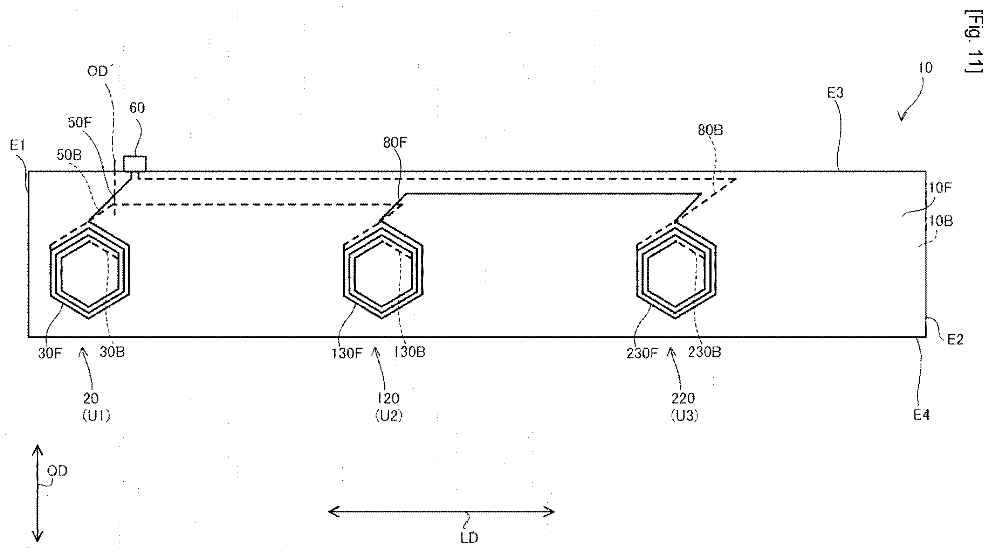

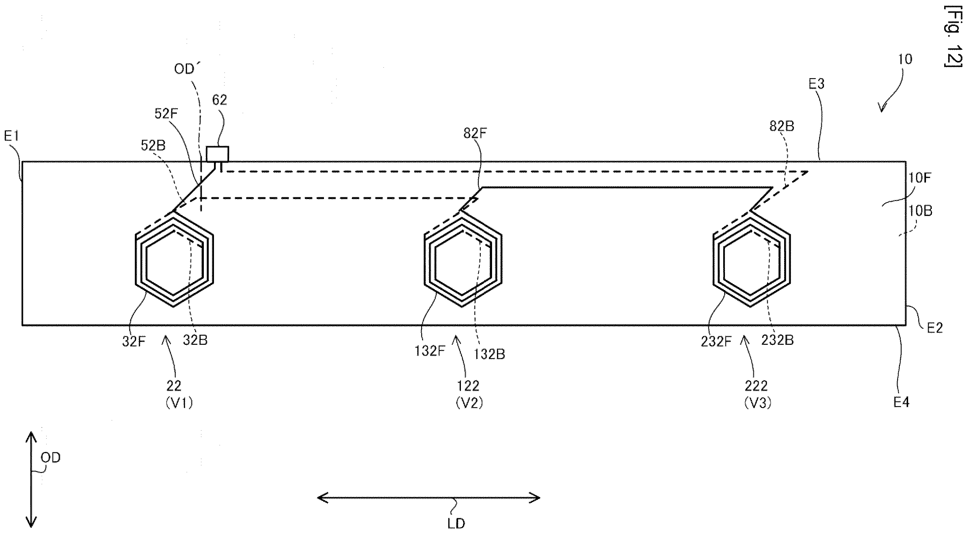

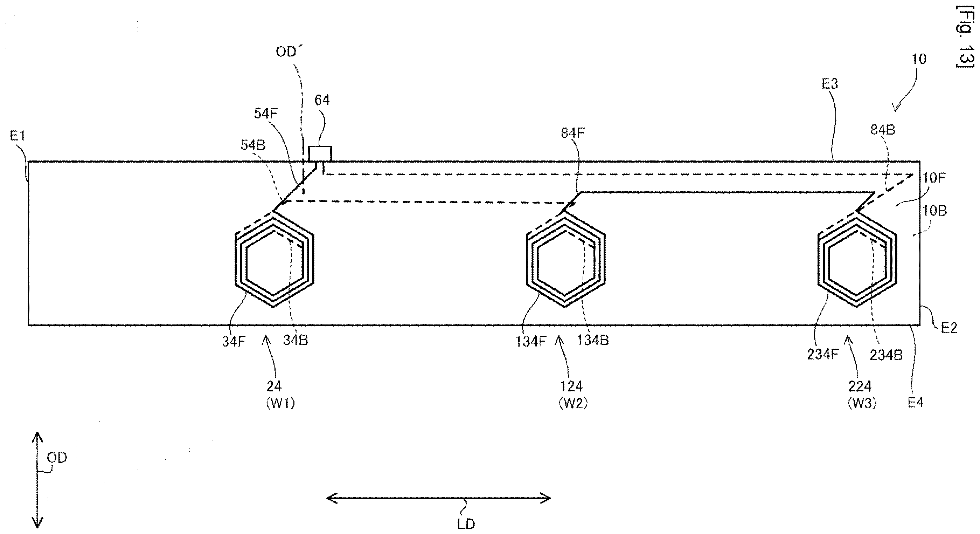

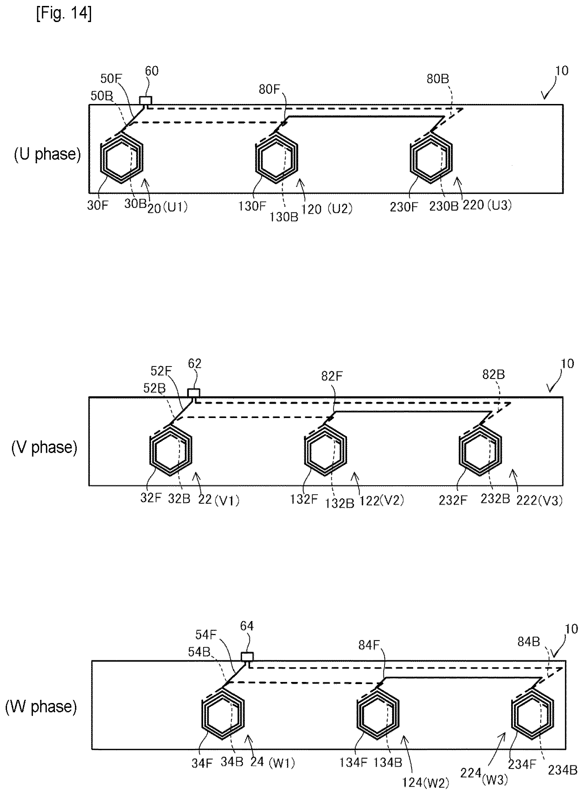

The other coils 22, 24, 120, 122, 124, 220, 222, 224 also have the same configuration as the coil 20. As shown in fig. 10, in modified example 1 also, the nine coils 20, 22, 24, 120, 122, 124, 220, 222, 224 are aligned along the longitudinal direction of the flexible board 10. The nine coils 20, 22, 24, 120, 122, 124, 220, 222, 224 are aligned in that order from the first edge E1 toward the second edge E2. As shown in fig. 11 and 14, the coils 20, 120, 220 constitute the U phase. As shown in fig. 12 and 14, the coils 22, 122, 222 constitute the V phase. As shown in fig. 13 and 14, the coils 24, 124, 224 constitute the W phase. As shown in fig. 14, the U phase, V phase and W phase are each arranged offset from each other along the longitudinal direction. The nine coils 20, 22, 24, 120, 122, 124, 220, 222, 224 are aligned along the longitudinal direction so as to be in the order of U phase, V phase and W phase. The U phase, V phase and W phase of a three-phase motor may be constructed in a different form to that described above.

As shown in fig. 10-14, the connecting wires 50F, 52F, 54F, 80F, 82F, 84F are also formed on the first face 10F side in modified example 1. The connecting wires 50B, 52B, 54B, 80B, 82B, 84B are formed on the second face 10B side.

As shown in fig. 11 and 14, the connecting wire 50F connects an end portion of the first wiring 30F constituting one end of the coil 20, and the terminal 60. The connecting wire 50B connects an end portion of the second wiring 30B constituting the other end of the coil 20, and an end portion of the second wiring 130B constituting one end of the coil 120. The connecting wire 80F connects an end portion of the first wiring 130F constituting the other end of the coil 120, and an end portion of the first wiring 230F constituting one end of the coil 220. The connecting wire 80B connects an end portion of the second wiring 230B constituting the other end of the coil 120, and the terminal 60. That is to say, the coils 20, 120, 220 constituting the U phase are connected in series by way of the connecting wires 50F, 50B, 80F, 80B and the terminal 60.

As shown in fig. 12 and 14, the connecting wire 52F connects an end portion of the first wiring 32F constituting one end of the coil 22, and the terminal 62. The connecting wire 52B connects an end portion of the second wiring 32B constituting the other end of the coil 22, and an end portion of the second wiring 132B constituting one end of the coil 122. The connecting wire 82F connects an end portion of the first wiring 132F constituting the other end of the coil 122, and an end portion of the first wiring 232F constituting one end of the coil 222. The connecting wire 82B connects an end portion of the second wiring 232B constituting the other end of the coil 122, and the terminal 62. The coils 22, 122, 222 constituting the V phase are connected in series by way of the connecting wires 52F, 52B, 82F, 82B and the terminal 62.

As shown in fig. 13 and 14, the connecting wire 54F connects an end portion of the first wiring 34F constituting one end of the coil 24, and the terminal 64. The connecting wire 54B connects an end portion of the second wiring 34B constituting the other end of the coil 24, and an end portion of the second wiring 134B constituting one end of the coil 124. The connecting wire 84F connects an end portion of the first wiring 134F constituting the other end of the coil 124, and an end portion of the first wiring 234F constituting one end of the coil 224. The connecting wire 84B connects an end portion of the second wiring 234B constituting the other end of the coil 124, and the terminal 64. The coils 24, 124, 224 constituting the W phase are connected in series by way of the connecting wires 54F, 54B, 84F, 84B and the terminal 64.

As shown in fig. 10-14, the connecting wires 50F, 52F, 54F, 80F, 82F, 84F formed on the first face 10F side extend obliquely (are inclined) in relation to the longitudinal direction (direction of the arrow LD). The connecting wires 50F, 52F, 54F, 80F, 82F, 84F are all largely free of parts extending in the orthogonal direction (direction of the arrow OD). The connecting wires 50F, 52F, 54F, 80F, 82F, 84F extend obliquely (are inclined) in relation to the orthogonal direction. As shown in fig. 11-13, the connecting wires 50F, 52F, 54F, 80F, 82F, 84F are all inclined, for example, by +5° or more, or -5° or more in relation to the imaginary line OD' parallel to the orthogonal direction, in terms of the interior angle formed by the imaginary line OD' and the connecting wires 50F, 52F, 54F, 80F, 82F, 84F. In addition, +10° to +45° in relation to the imaginary line OD' is preferable for the interior angle with the connecting wires 50F, 52F, 54F, 80F, 82F, 84F. As a result, a motor coil board obtained by winding the coil board can be formed into a cylindrical shape with a circular cross section. Furthermore, the gaps which are formed between the connecting wire 50F and the connecting wire 52F, between the connecting wire 52F and the connecting wire 54F, between the connecting wire 54F and the connecting wire 80F, between the connecting wire 80F and the connecting wire 82F, and between the connecting wire 82F and the connecting wire 84F also extend obliquely in relation to both the longitudinal direction and the orthogonal direction.

As shown in fig. 10-14, the connecting wires 50B, 52B, 54B, 80B, 82B, 84B formed on the second face 10B side also all extend obliquely (are inclined) in relation to the longitudinal direction (direction of the arrow LD). The connecting wires 50B, 52B, 54B, 80B, 82B, 84B are also all largely free of parts extending in the orthogonal direction (direction of the arrow OD). The connecting wires 50B, 52B, 54B, 80B, 82B, 84B extend obliquely (are inclined) in relation to the orthogonal direction. In modified example 1, the connecting wires 50B, 52B, 54B, 80B, 82B, 84B are inclined by +30° in relation to the imaginary line OD'. As shown in fig. 11-13, the connecting wires 50B, 52B, 54B, 80B, 82B, 84B are also all inclined, for example, by +5° or more, or -5° or more in relation to the imaginary line OD' parallel to the orthogonal direction, in terms of the interior angle formed by the imaginary line OD' and the connecting wires 50B, 52B, 54B, 80B, 82B, 84B. In addition, +10° to +45° in relation to the imaginary line OD' is preferable for the interior angle with the connecting wires 50B, 52B, 54B, 80B, 82B, 84B. As a result, a motor coil board obtained by winding the coil board can be formed into a cylindrical shape with a circular cross section. The gaps which are formed between the connecting wire 50B and the connecting wire 52B, between the connecting wire 52B and the connecting wire 54B, between the connecting wire 54B and the connecting wire 80B, between the connecting wire 80B and the connecting wire 82B, and between the connecting wire 82B and the connecting wire 84B also extend obliquely in relation to both the longitudinal direction and the orthogonal direction.

In modified example 1 also, the first face 10F, the first wiring 30F, 32F, 34F, 130F, 132F, 134F, 230F, 232F, 234F, and the connecting wires 50F, 52F, 54F, 80F, 82F, 84F are covered over by a resin insulating layer, although this is not shown in the drawings. The second face 10B, the second wiring 30B, 32B, 34B, 130B, 132B, 134B, 230B, 232B, 234B, and the connecting wires 50B, 52B, 54B, 80B, 82B, 84B are likewise covered over by a resin insulating layer.

### [Modified Example 2 of the Embodiment]

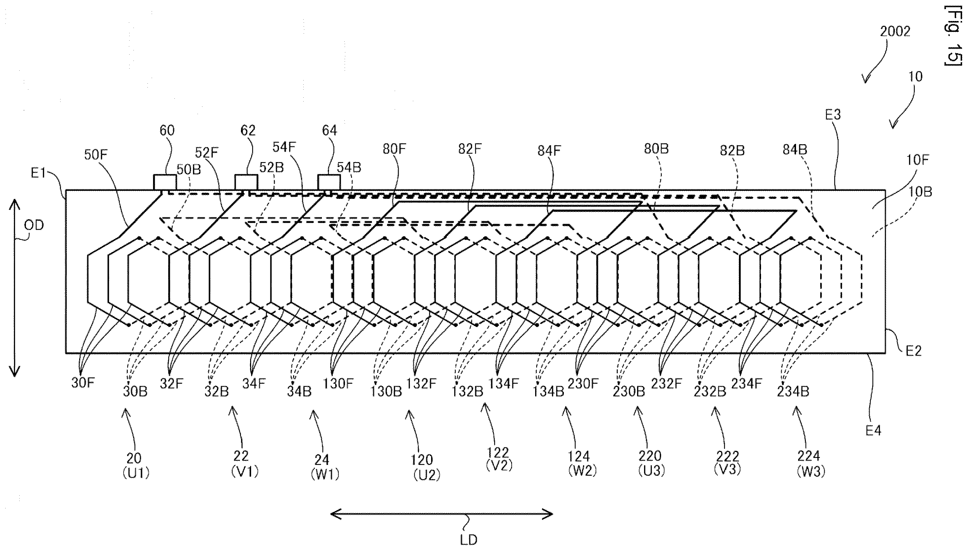

Fig. 15 shows modified example 2 of the embodiment. Fig. 15 is a plan view showing a coil board 2002 according to modified example 2. In modified example 2, the arrangement of the wiring constituting the coils 20, 22, 24, 120, 122, 124, 220, 222, 224, etc. is similar to that of the embodiment. In modified example 2, the direction in which the connecting wires 50B, 52B, 54B, 80B, 82B, 84B extend is different from that of the embodiment. The configuration of modified example 2 is similar to that of the embodiment, except for the direction in which the connecting wires 50B, 52B, 54B, 80B, 82B, 84B extend, so a detailed description thereof will not be given.

As shown in fig. 15-19, the connecting wires 50F, 52F, 54F, 80F, 82F, 84F are also formed on the first face 10F side in modified example 2. The connecting wires 50B, 52B, 54B, 80B, 82B, 84B are formed on the second face 10B side.

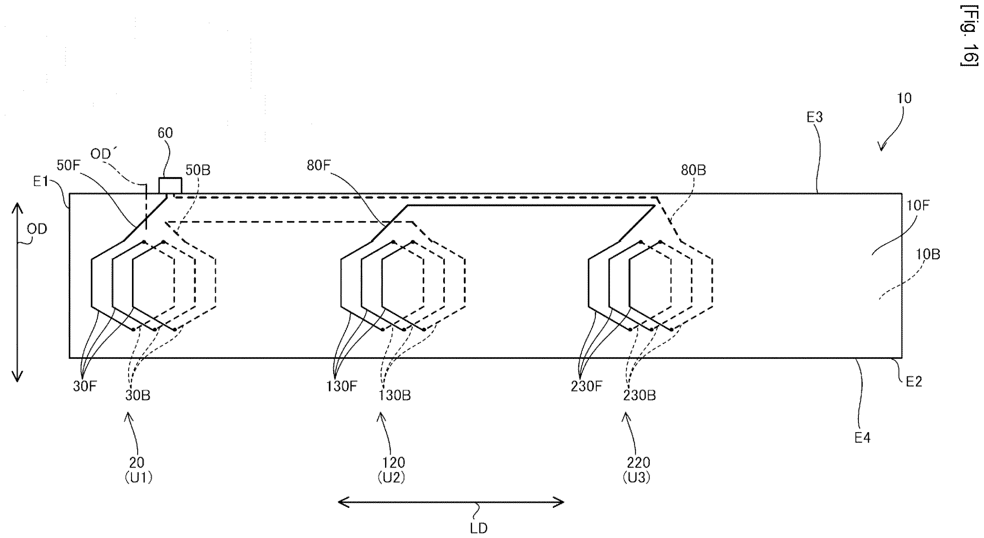

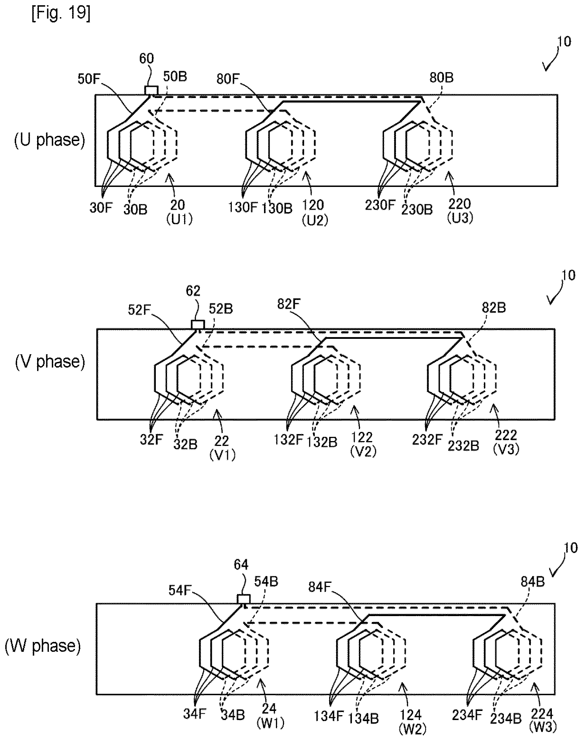

As shown in fig. 16 and 19, in modified example 2 also, the coils 20, 120, 220 constituting the U phase are connected in series by way of the connecting wires 50F, 50B, 80F, 80B and the terminal 60. In modified example 2, however, the connecting wire 50B extends in a direction intersecting the connecting wire 50F (at a different angle of inclination), when the flexible board 10 is seen from the first face 10F side. In the same way, the connecting wire 80B also extends in a direction intersecting the connecting wire 80F (at a different angle of inclination).

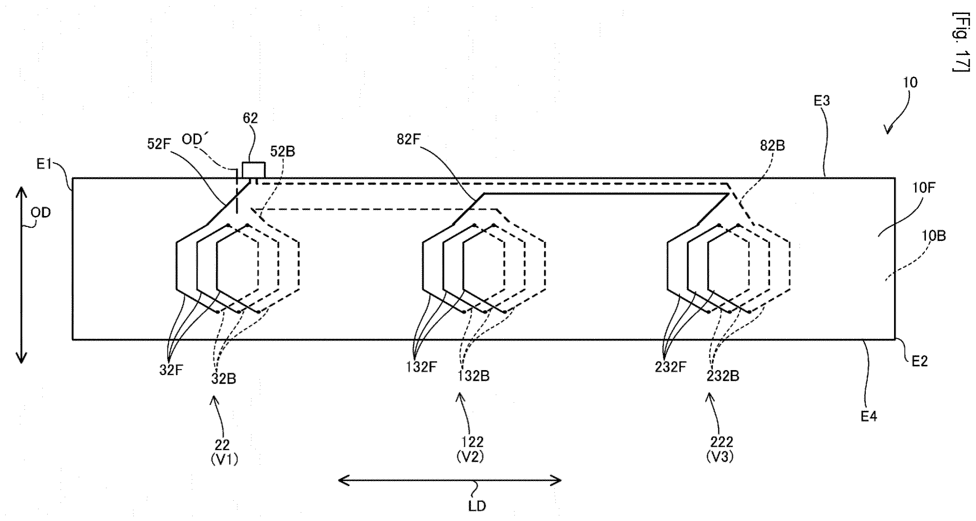

As shown in fig. 17 and 19, in modified example 2 also, the coils 22, 122, 222 constituting the V phase are connected in series by way of the connecting wires 52F, 52B, 82F, 82B and the terminal 62. In modified example 2, however, the connecting wire 52B extends in a direction intersecting the connecting wire 52F (at a different angle of inclination), when the flexible board 10 is seen from the first face 10F side. In the same way, the connecting wire 82B also extends in a direction intersecting the connecting wire 82F (at a different angle of inclination). In modified example 2, the connecting wires 50F, 52F, 54F, 80F, 82F, 84F are inclined by +30° in relation to the imaginary line OD'. The connecting wires 50B, 52B, 54B, 80B, 82B, 84B are inclined by -30° in relation to the imaginary line OD'.

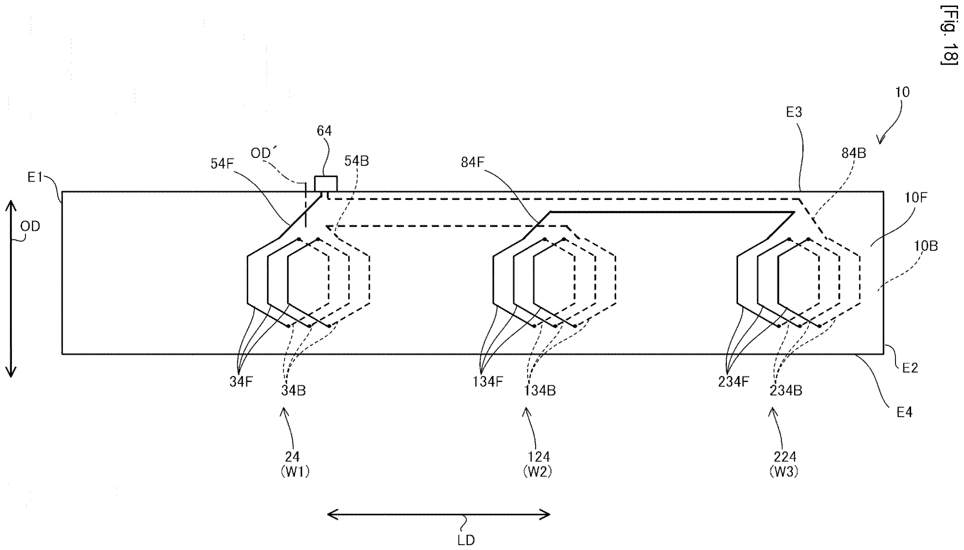

As shown in fig. 18 and 19, in modified example 2 also, the coils 24, 124, 224 constituting the W phase are connected in series by way of the connecting wires 54F, 54B, 84F, 84B and the terminal 64. In modified example 2, however, the connecting wire 54B extends in a direction intersecting the connecting wire 54F (at a different angle of inclination), when the flexible board 10 is seen from the first face 10F side. In the same way, the connecting wire 84B also extends in a direction intersecting the connecting wire 84F (at a different angle of inclination).

### [Modified Example 3 of the Embodiment]

The configuration of the coil board of modified example 3 is the same as that of the embodiment. In modified example 3, the connecting wires 50F, 52F are inclined by +40° in relation to the imaginary line OD'.

### [Modified Example 4 of the Embodiment]

The configuration of the coil board of modified example 4 is the same as that of modified example 1. In modified example 4, the connecting wires 50B, 52B, 54B, 80B, 82B, 84B are inclined by +40° in relation to the imaginary line OD'.

### [Modified Example 5 of the Embodiment]

The configuration of the coil board of modified example 5 is the same as that of modified example 2. In modified example 5, the connecting wires 50F, 52F, 54F, 80F, 82F, 84F are inclined by +40° in relation to the imaginary line OD'. The connecting wires 50B, 52B, 54B, 80B, 82B, 84B are inclined by -40° in relation to the imaginary line OD'.

### [Key to Symbols]

2, 1002, 2002: Coil board
10: Flexible board
10F: First face
10B: Second face
20, 22, 24, 120, 122, 124, 220, 222, 224: Coil
50F, 50B, 52F, 52B, 54F, 54B, 80F, 80B, 82F, 82B, 84F, 84B: Connecting wire
60, 62, 64: Terminal
550: Motor coil board
560: Yoke
570: Magnet
580: Rotary shaft
600: Motor
G: Gap

## Claims

1. A coil board comprising: a flexible board having a first face and a second face on the opposite side to the first face;
coils formed by coil-shaped wiring provided on the first face and coil-shaped wiring provided on the second face;
terminals formed on one edge in a width direction of the flexible board; and
connecting wires for connecting the terminals and the wiring of the coils, or connecting wires for connecting the wiring of two coils, wherein
the coil board is wound along a longitudinal direction of the flexible board about an axis extending in an orthogonal direction which is orthogonal to the longitudinal direction, starting from a reference edge on one end side of the flexible board in the longitudinal direction, and can thereby be formed into a cylindrical shape, and
the connecting wires extend obliquely in relation to the longitudinal direction.

2. The coil board of claim 1, wherein a gap which is formed between two adjacent connecting wires extends obliquely in relation to the longitudinal direction.

3. The coil board of claim 1, wherein the connecting wires include a first face-side connecting wire formed on the first face side, and a second face-side connecting wire formed on the second face side, the first face-side connecting wire and the second face-side connecting wire extending in intersecting directions, when the flexible board is seen from the first face side.

4. The coil board of claim 1, wherein the coils comprise first wiring constituting a half turn of one turn formed on the first face side, and second wiring constituting a remaining half turn formed on the second face side, the first wiring and the second wiring constituting each turn being electrically connected through a via conductor.

5. The coil board of claim 1, wherein the connecting wires are inclined by +5° or more, or - 5° or more, in relation to an imaginary line parallel to the orthogonal direction.

6. The coil board of claim 1, wherein the connecting wires are inclined by +10° to +45°, or - 10° to -45°, in relation to an imaginary line parallel to the orthogonal direction.

7. A motor coil board formed by winding the coil board of claim 1 along the longitudinal direction, wherein the first face is arranged on an inner face side, and the second face is arranged on an outer face side.

8. A motor which is formed by arranging the motor coil board of claim 7 on the inside of a cylindrical yoke, and arranging a rotary shaft and a magnet on the inside of the motor coil board
